# EUROPÄISCHE PATENTSCHRIFT

(11) **EP 2 050 150 B1**
(45) Veröffentlichungstag und Bekanntmachung des Hinweises auf die Patenterteilung: **24.04.2013**
(21) Anmeldenummer: 07801506.2
(22) Anmeldetag: 03.08.2007
(51) Int. Cl.: H01L 51/00, G03F 1/00

(54) **VERFAHREN ZUR HERSTELLUNG MINDESTENS EINES MEHRSCHICHTKÖRPERS SOWIE MEHRSCHICHTKÖRPER**
METHOD FOR PRODUCING AT LEAST ONE MULTILAYER BODY, AND MULTILAYER BODY
PROCÉDÉ DE FABRICATION D'AU MOINS UN CORPS MULTICOUCHE ET CORPS MULTICOUCHE

(30) Priorität: 09.08.2006 DE 102006037433
(43) Veröffentlichungstag der Anmeldung: 22.04.2009
(73) Patentinhaber: OVD Kinegram AG, 6301 Zug (CH)
(72) Erfinder: SCHNEIDER, Gernot, CH-6340 Baar (CH); STAUB, René, CH-6332 Hagendorn (CH); TOMPKIN, Wayne, Robert, CH-5400 Baden (CH); HANSEN, Achim, CH-6300 Zug (CH)
(74) Vertreter: Louis Pöhlau Lohrentz
(86) Internationale Anmeldenummer: PCT/EP2007/006884
(87) Internationale Veröffentlichungsnummer: WO 2008/017426

(56) Entgegenhaltungen:
- EP-A- 1 624 338
- EP-A1- 0 673 045
- WO-A-2004/079833
- WO-A2-2005/039868
- DE-A1-102004 059 798
- US-A- 3 829 213
- US-A1- 2002 195 928
- US-A1- 2004 009 413
- Vortragsunterlagen von Prof. Dr. Arved Hübler, "Printing Technologies for Polytronic Structures", 1st Polyscene Workshop at IMEC in Leuven, Belgium
- A. HÜBLER: "Funktionale Polymere - Gedruckte Elektronik als Chance", DEGUSSA SCIENCENEWSLETTER, ELEMENTS, vol. 13, 2005, pages 10-13,
- Helmut Kipphan: "Handbook of Print Media", 2000, Springer Verlag ISBN: 3-540-66941-8 page 1164,
- 'Fabricating Printed Circuit Boards', 01 Januar 2002, ELSEVIER SCIENCE (USA), ISBN 978-1-87-870750-5 vol. JON VARTERESIAN: 'Making Printed Circuit Boards', Seiten 69 - 72, XP055042087

## Beschreibung

Die Erfindung betrifft ein Verfahren zur Herstellung eines Mehrschichtkörpers, insbesondere eines Mehrschichtkörpers mit mindestens einem elektronischen Bauelement, wobei der Mehrschichtkörper mindestens zwei Funktionsschichten, insbesondere elektrische Funktionsschichten, auf einer Oberseite eines Trägersubstrats umfasst, welche im Register zueinander strukturiert sind. Die Erfindung betrifft weiterhin einen danach erhältlichen Mehrschichtkörper.

US 2004/0009413 beschreibt Schwarzweißmasken zür Strukturierung von mikromechanischen Vorrichtungen.

DE 10 2004 059 467 A1 beschreibt elektronische Bauelemente in Form von organischen Feldeffekttransistoren (OFET), welche zu einem Logik-Gatter verschaltet sind sowie deren Herstellung auf einem Trägersubstrat. Die Feldeffekttransistoren sind aus mehreren funktionalen Schichten bzw. Funktionsschichten ausgebildet, die auf das Trägersubstrat insbesondere durch Drucken oder Rakeln aufgebracht werden. Das Trägersubstrat ist unter anderem als Kunststoff-Folie mit einer Stärke im Bereich von 6 bis 200 µm ausgebildet.

Dicke Trägersubstrate waren dabei bislang bevorzugt, da es sich bei der Verarbeitung dünner, kostengünstigerer Trägersubstrate mit einer Dicke im Bereich von 6 bis etwa 50 µm gezeigt hat, dass diese zu einem Verziehen während der Verarbeitung neigen, wobei der Verzug sich mit jedem Verarbeitungsschritt ändert. Wird auf das dünne Trägersubstrat eine elektrische Funktionsschicht aufgebracht und strukturiert, so ergibt sich bereits ein merklicher Verzug bzw. senkrecht zum Trägersubstrat gesehen eine Abweichung der Form der Funktionsschicht von deren Idealform. Der Verzug wirkt sich besonders störend aus, wenn nachfolgend oder nach Aufbringung einer oder mehrerer vollflächiger Funktionsschichten, verbunden mit einer weiteren Änderung der Dimensionen der bereits gebildeten strukturierten Funktionsschicht, eine weitere strukturierte Funktionsschicht zu der bereits gebildeten strukturierten Funktionsschicht im Register angeordnet werden muss.

Es ist daher Aufgabe der Erfindung, ein verbessertes Verfahren zur Herstellung eines Mehrschichtkörpers mit im Register zueinander strukturierten Funktionsschichten sowie danach herstellbare Bauelemente anzugeben, insbesondere ein verbessertes Verfahren zur Herstellung elektronischer Bauelemente auf zum Verziehen neigenden Trägersubstraten bereitzustellen.

Die Aufgabe wird für das Verfahren zur Herstellung eines Mehrschichtkörpers, der mindestens zwei insbesondere elektrische Funktionsschichten auf einer Oberseite eines Trägersubstrats umfasst, welche im Register zueinander strukturiert sind, dadurch gelöst, dass eine Unterseite des Trägersubstrats derart präpariert wird, dass in einem ersten Bereich eine Durchlässigkeit für eine erste Belichtungsstrahlung und in mindestens einem zweiten Bereich eine Durchlässigkeit für mindestens eine dazu unterschiedliche zweite Belichtungsstrahlung im Register zum ersten Bereich resultiert, dass die Unterseite nacheinander mit der ersten und der mindestens einen zweiten Belichtungsstrahlung belichtet wird, und dass die erste Belichtungsstrahlung zur Strukturierung einer ersten Funktionsschicht und die mindestens eine zweite Belichtungsstrahlung zur Strukturierung mindestens einer zweiten Funktionsschicht auf der Oberseite des Trägersubstrats verwendet wird.

Das erfindungsgemässe Verfahren ermöglicht trotz eines Verzugs des Trägersubstrats bei dessen Verarbeitung eine unproblematische Anordnung der mindestens einen zweiten Funktionsschicht im perfekten oder nahezu perfekten Register zur ersten Funktionsschicht, da der auftretende Verzug gleichermassen den ersten Bereich und den mindestens einen zweiten Bereich betrifft. Die Form des ersten Bereichs wird senkrecht zur Ebene des Trägersubstrats gesehen im Einklang mit der Form des mindestens einen zweiten Bereichs durch den Verzug verändert, so dass sich die Lage des ersten Bereichs hinsichtlich der Lage des mindestens einen zweiten Bereichs nicht verschieben kann. Die Lage des ersten Bereichs sowie des mindestens einen zweiten Bereichs wird somit bereits zu Beginn des Herstellungsverfahrens auf dem Trägersubstrat festgelegt, so dass eine Ungenauigkeit in der Ausrichtung der ersten Funktionsschicht gegenüber der mindestens einen zweiten Funktionsschicht trotz eines Verzugs des Trägersubstrats nicht mehr auftreten kann. Die mindestens eine zweite Funktionsschicht wird in einer von ihrer Idealform abweichenden und in einer an die aktuell vorliegende Form der ersten Funktionsschicht angepassten Form lagegenau zur ersten Funktionsschicht ausgebildet. Aufgrund der genauen Positionierung der Funktionsschichten zueinander ist es nun möglich, hochwertige optische und/oder elektrische Bauelemente mit verbesserten optischen bzw. elektrischen Eigenschaften bei gleichzeitig geringerem Platzbedarf auf dem Trägersubstrat auszubilden.

So werden bei der Herstellung von OFETs auf einem dünnen Trägersubstrat aufgrund der optimalen Ausrichtung der Source/Drain-Elektroden gegenüber der Gate-Elektrode deutlich niedrigere Gate-Kapazitäten erreicht, so dass eine Schaltgeschwindigkeit der OFETs deutlich erhöht ist. Während bei den früheren Herstellungsmethoden ca. 80 % der Fläche des Trägersubstrats für die Berücksichtigung von Toleranzen bei der Herstellung der einzelnen Funktionsschichten verloren ging, ist nun eine deutlich bessere Ausnutzung der Fläche des Trägersubstrats möglich, so dass um bis zu 100 % mehr elektronische Bauelemente auf einem Trägersubstrat gebildet werden können.

Das erfindungsgemässe Verfahren bietet sich hier weiter vor allem zur Herstellung von optischen Bauelementen an, welche zwei strukturierte, von einer Abstandsschicht voneinander getrennte Funktionsschichten umfassen. Die beiden strukturierten Funktionsschichten können hierbei metallische oder farbige Schichten sein. Bevorzugt handelt es sich bei der ersten Funktionsschicht um eine opake Maskenschicht, welche bei Betrachtung eine winkelabhängige geometrische Abschattung der zweiten strukturierten Funktionsschicht bewirkt und so je nach Blickwinkel beispielsweise ein Farbflipp oder einen Wechsel der dargestellten Bildinformation erzeugt. Auch hier ist es möglich, dass die zwei oder mehr unabhängig voneinander strukturierbaren Funktionsschichten unmittelbar aufeinander liegen und so beispielsweise ein Farbbild durch additive oder substraktive Farbmischung bilden. Bei den Funktionsschichten kann es sich weiter auch um IR- oder UV-lumineszente unabhängig voneinander strukturierbare Schichten oder um Schichten handeln, die mit optisch variablen Pigmenten (Dünnfilmschicht-Pigmente, Flüssigkristall-Pigmente) versehen sind. Weiter ist es auch möglich, dass die optischen Funktionsschichten im weiteren auch von einem diffraktiven Oberflächen-Relief überlagert sind und so beispielsweise metallische oder dielektrische Reflexionsschichten darstellen, die die Generierung eines partiell vorhandenen optisch variablen Effekts (beispielsweise Hologramm) ermöglichen.

Es kann vorgesehen sein, das Trägersubstrat auf der Unterseite direkt mit Reliefstrukturen zu versehen oder eine auf die Unterseite aufgebrachte Schicht, insbesondere aus einem thermoplastischen Material oder einem UV-Lack, mit Reliefstrukturen zu versehen. Dabei kann ein Spritzgusswerkzeug zum Einsatz kommen oder die Reliefstrukturen mittels Abformen eines Stempels in UV-Lack oder mittels eines gegebenenfalls beheizten Stempels in thermoplastischem Material gebildet werden. Auch die Verwendung einer klassischen Photolithographiemethode zur Bildung der Reliefstrukturen auf der Unterseite des Trägersubstrats, bei der ein Photoresist aufgetragen, belichtet, entwickelt und als Ätzmaske für die Unterseite verwendet wird, ist ohne weiteres möglich.

Die Aufgabe wird für einen Mehrschichtkörper, insbesondere umfassend ein organisches elektronisches Bauelement, welcher ein Trägersubstrat aus einem flexiblen Folienmaterial, insbesondere einem Kunststofffolienmaterial, aufweist, dadurch gelöst, dass eine Unterseite des Trägersubstrats derart präpariert ist, dass in einem ersten Bereich eine Durchlässigkeit für eine erste Belichtungsstrahlung und in mindestens einem zweiten Bereich eine Durchlässigkeit für mindestens eine dazu unterschiedliche zweite Belichtungsstrahlung im Register zum ersten Bereich ausgebildet ist, und dass auf einer Oberseite des Trägersubstrats mindestens zwei strukturierte Funktionsschichten im Register zueinander und weiterhin im Register zu dem ersten und dem mindestens einen zweiten Bereich angeordnet sind.

Das Trägersubstrat weist hierbei eine Dicke im Bereich von 3 µm bis 250 µm, bevorzugt 6 µm bis 50 µm auf.

Die erste und zweite Belichtungsstrahlung können sich hierbei beispielsweise durch ihre Wellenlänge, Polarisation, spektrale Zusammensetzung, den Beleuchtungseinfallwinkel, etc. unterscheiden.

Das Bauelement weist aufgrund der genauen Positionierung der Funktionsschichten zueinander besonders gute und reproduzierbare optische und/oder elektrische Eigenschaften bei gleichzeitig geringem Platzbedarf auf.

In einer ersten Variante des erfindungsgemässen Verfahrens wird die Unterseite des Trägersubstrats präpariert, indem im ersten Bereich eine erste Reliefstruktur und im zweiten Bereich und im Register zur ersten Reliefstruktur mindestens eine, zur ersten Reliefstruktur unterschiedliche zweite Reliefstruktur gebildet wird, dass auf die Unterseite weiterhin eine Belichtungsmaskenschicht aufgebracht wird, wobei die Belichtungsmaskenschicht mit einer konstanten Flächendichte bezogen auf eine von der Trägerschicht aufgespannte Ebene aufgebracht wird, dass im Register zur ersten Reliefstruktur die auf die Oberseite des Trägersubstrat aufgebrachte erste Funktionsschicht strukturiert wird und dass im Register zu der mindestens einen zweiten Reliefstruktur die mindestens eine auf die Oberseite des Trägersubstrats aufgebrachte zweite elektrische Funktionsschicht strukturiert wird. Bei diesem Ausführungsbeispiel der Erfindung wird keine Belichtungsmaskenschicht benötigt.

Der ersten Variante des Verfahrens liegt die Erkenntnis zugrunde, dass durch die Reliefstrukturen im ersten und mindestens einen zweiten Bereich physikalische Eigenschaften der auf das Trägersubstrat aufgebrachten Belichtungsmaskenschicht, beispielsweise effektive Dicke oder optische Dichte, beeinflusst werden, so dass sich die Transmissions-Eigenschaften der Belichtungsmaskenschicht im ersten und zweiten Bereich unterscheiden. Die Belichtungsmaskenschicht wird in einem Belichtungsverfahren als Maske für die Teilentfernung der ersten elektrischen Funktionsschicht und weiterhin auch für die Teilentfernung der mindestens einen zweiten elektrischen Funktionsschicht verwendet, indem jeweils eine photoempfindliche Schicht auf der Oberseite des Trägersubstrats durch die Belichtungsmaskenschicht - also auch durch das Trägersubstrat - hindurch belichtet und partiell entfernt wird, so dass eine Strukturierung der ersten bzw. der zweiten Funktionsschicht unmittelbar erfolgt oder danach erfolgen kann.

Hierdurch wird gegenüber den mit herkömmlichen Verfahren aufgebrachten Funktionsschichten der Vorteil erzielt, dass diese ohne zusätzlichen Justieraufwand registergenau zueinander ausgerichtet sind. Es haben nur die Toleranzen der Reliefstrukturen Einfluss auf die Toleranzen der Lage der beiden Funktionsschichten. Die Anordnung von Bereichen der Belichtungsmaskenschicht mit gleichen physikalischen Eigenschaften erfolgt exakt im Register zum ersten und mindestens einen zweiten Bereich.

Das Trägersubstrat ist dabei möglichst dünn zu wählen, da der Abstand zwischen der strukturierten Schicht und der z.B. photoaktiven Schicht auf der gegenüberliegenden Seite, insbesondere bei dicken Trägern, einen Einfluss auf die Qualität/Auflösung/Register der Funktionsschicht haben kann.

Bei der Belichtungsmaskenschicht handelt es sich um eine Schicht, die eine Doppel-Funktion erfüllt, da sie die Funktion einer hochgenauen Belichtungsmaske für den Herstellungsprozess von unterschiedlich strukturierten Funktionsschichten erbringt.

Die Belichtungsmaskenschicht wird auf das Trägersubstrat vorzugsweise mittels Sputtern, Aufdampfen oder Aufsprühen aufgebracht. Beim Sputtern liegt prozessbedingt ein gerichteter Materialauftrag vor, so dass bei einem Aufsputtern von Material der Belichtungsmaskenschicht in konstanter Flächendichte bezogen auf die von dem Trägersubstrat aufgespannte Ebene das Material auf das mit den Reliefstrukturen versehene Trägersubstrat lokal unterschiedlich dick abgelagert wird. Beim Aufdampfen und Aufsprühen der Belichtungsmaskenschicht wird verfahrenstechnisch vorzugsweise ebenfalls ein zumindest teilweise gerichteter Materialauftrag erzeugt. Der Materialauftrag kann dabei nicht nur senkrecht, sondern auch in einem Winkel im Bereich von 30 bis 150° zur von dem Trägersubstrat aufgespannten Ebene erfolgen. Dies ist insbesondere bei der Verwendung periodischer symmetrischer oder asymmetrischer Reliefstrukturen von Vorteil, welche gezielt partiell beschichtet werden sollen.

Dabei wird die Belichtungsmaskenschicht vorzugsweise von einer Metallschicht oder von einer Schicht aus einer Metalllegierung gebildet. Solche Schichten können mit bewährten Verfahren, wie Sputtern, aufgebracht werden, und sie weisen bereits bei geringen Schichtdicken eine hinreichende optische Dichte auf. Es kann sich bei der Belichtungsmaskenschicht aber auch um eine nichtmetallische Schicht handeln, die beispielsweise eingefärbt sein kann, Flüssigkristalle enthalten kann oder dotiert sein kann, beispielsweise mit Nano-Partikeln oder mit Nano-Sphären, um ihre optische Dichte zu erhöhen.

Weiter kann vorgesehen sein, dass die Belichtungsmaskenschicht auf das Trägersubstrat in einer Dicke aufgebracht wird, bei der die Belichtungsmaskenschicht weitgehend opak ist, vorzugsweise eine optische Dichte von grösser als 1,5 besitzt.

Überraschender Weise hat sich gezeigt, dass sich durch die Erhöhung der Opazität der Belichtungsmaskenschicht das Verhältnis der Transmissivitäten der Bereiche mit unterschiedlicher diffraktiver Reliefstruktur vergrössern lässt. Wird mit entsprechender Beleuchtungsstärke durch eine üblicherweise als opak bezeichnete Belichtungsmaskenschicht (beispielsweise optische Dichte von 5) belichtet, die aufgrund ihrer hohen optischen Dichte normalerweise nicht als Maskenschicht eingesetzt werden würde, lassen sich besonders gute Ergebnisse erzielen.

Von besonderem Vorteil ist, wenn die Belichtungsmaskenschicht auf das Trägersubstrat vollflächig in einer Dicke aufgebracht wird, bei der die Belichtungsmaskenschicht eine optische Dichte zwischen 2 und 7 besitzt. Zur Ausbildung besonders grosser Unterschiede der optischen Dichte der ersten und der zweiten Reliefstruktur kann in dem ersten Bereich als erste Reliefstruktur eine diffraktive Reliefstruktur mit einem hohem Tiefen-zu-Breiten-Verhältnis der einzelnen Strukturelemente, insbesondere mit einem Tiefen-zu-Breiten-Verhältnis > 0,3, abgeformt werden und die zweite Reliefstruktur als Reliefstruktur mit niedrigerem Tiefen-zu-Breiten-Verhältnis ausgebildet werden.

Durch die Verwendung derartiger spezieller diffraktiver Reliefstrukturen ist es bei geeigneter Wahl der Schichtdicke der Belichtungsmaskenschicht möglich, sehr grosse, bereits mit dem Auge erkennbare Unterschiede in der optischen Dichte der ersten Schicht im ersten Bereich und im zweiten Bereich zu generieren. Überraschenderweise wurde jedoch festgestellt, dass derart grosse Unterschiede in der Transmission im ersten und im zweiten Bereich für die Umsetzung des erfindungsgemässen Verfahrens nicht zwingend sind. Es kommt nur darauf an, dass sich der erste und der mindestens eine zweite Bereich durch ihre Transmissionseigenschaften beziehungsweise eine geringere oder eine grössere optische Dichte abgrenzen.

In einer vorteilhaften Ausgestaltung ist vorgesehen, dass die photoempfindliche Schicht durch die Belichtungsmaskenschicht hindurch mittels UV-Strahlung belichtet wird. Experimente haben gezeigt, dass die durch die unterschiedliche Gestaltung der Reliefstruktur im ersten und zweiten Bereich erzielbaren Unterschiede in den Transmissionseigenschaften der Belichtungsmaskenschicht im Bereich der UV-Strahlung besonders ausgeprägt sind. Bei der Verwendung von UV-Strahlung für die Belichtung lassen sich so besonders gute Ergebnisse erzielen.

Reliefstrukturen mit geringen Unterschieden im Tiefen-zu-Breiten-Verhältnis weisen bei dünner Bedampfung auch üblicherweise relativ geringe Unterschiede in der Transmission auf. Selbst geringe relative Unterschiede können jedoch verstärkt werden durch Vergrösserung der Schichtdicke der Belichtungsmaskenschicht und damit der mittleren optischen Dichte. So lassen sich bereits bei recht geringen Unterschieden der Transmission der Belichtungsmaskenschicht im ersten und im zweiten Bereich gute Ergebnisse erzielen. Bei der Belichtungsmaskenschicht kann es sich um eine sehr dünne Schicht in der Grössenordnung von einigen nm handeln. Die mit gleichmässiger Flächendichte bezogen auf die von dem Trägersubstrat aufgespannte Ebene aufgetragene Belichtungsmaskenschicht ist in Bereichen mit einem hohen Tiefen-zu-Breiten-Verhältnis erheblich dünner ausgebildet als in Bereichen mit niedrigerem Tiefen-zu-Breiten-Verhältnis.

Das dimensionslose Tiefen-zu-Breiten-Verhältnis h/d ist ein kennzeichnendes Merkmal für die Vergrösserung der Oberfläche bei Verwendung von vorzugsweise periodischen Strukturen, beispielsweise mit sinusquadratischem Verlauf. Als Tiefe ist hier der Abstand zwischen dem höchsten und dem tiefsten aufeinander folgenden Punkt einer solchen Struktur bezeichnet, d.h. es handelt sich um den Abstand zwischen "Berg" und "Tal". Als Breite ist der Abstand zwischen zwei benachbarten höchsten Punkten, d.h. zwischen zwei "Bergen", bezeichnet. Je höher nun das Tiefen-zu-Breiten-Verhältnis ist, desto steiler sind die "Bergflanken" ausgebildet und desto dünner ist die auf den "Bergflanken" abgeschiedene erste Schicht ausgebildet. Der Effekt der Ausbildung höherer Transmission oder Transparenz bei Zunahme des Tiefen-zu-Breiten-Verhältnisses wird auch bei Strukturen mit vertikalen Flanken beobachtet, beispielsweise bei Rechteckgittern. Es kann sich aber auch um Strukturen handeln, auf die dieses Modell nicht anwendbar ist. Beispielsweise kann es sich um diskret verteilte linienförmige Bereiche handeln, die nur als ein "Tal" ausgebildet sind, wobei der Abstand zwischen zwei "Tälern" um ein Vielfaches höher ist als die Tiefe der "Täler". Bei formaler Anwendung der vorstehend genannten Definition würde das so berechnete Tiefen-zu-Breiten-Verhältnis annähernd Null sein und nicht das charakteristische physikalische Verhalten widerspiegeln. Deshalb ist bei diskret angeordneten Strukturen, die im wesentlichen nur aus einem "Tal" gebildet sind, die Tiefe des "Tales" zur Breite des "Tales" ins Verhältnis zu setzen.

Der Grad der Verringerung der optischen Dichte kann in Abhängigkeit vom Untergrund, von der Beleuchtung usw. variieren. Eine wichtige Rolle spielt dabei die Absorption des Lichtes in der Belichtungsmaskenschicht.

Tabelle 1 zeigt den ermittelten Reflexionsgrad von zwischen Plastikfolien (Brechungsindex n = 1,5) angeordneten Belichtungsmaskenschichten aus Metall, insbesondere aus Ag, Al, Au, Cr, Cu, Rh und Ti bei einer LichtWellenlänge λ = 550 nm. Das Dickenverhältnis ε ist hierbei als Quotient aus der für den Reflexionsgrad R = 80% des Maximums Rₘₐₓ und der für den Reflexionsgrad R = 20% des Maximums Rₘₐₓ erforderlichen Dicke t der Metallschicht gebildet.

**Tabelle 1**

| **Metall** | **R_{Max}** | **t für 80 % R_{Max}** | **t für 20% R_{Max}** | **ε** | **h/d** |
|---|---|---|---|---|---|
| Ag | 0,944 | 31 nm | 9 nm | 3,4 | 1,92 |
| Al | 0,886 | 12 nm | 2,5 nm | 4,8 | 2,82 |
| Au | 0,808 | 40 nm | 12 nm | 3,3 | 1,86 |
| Rh | 0,685 | 18 nm | 4,5 nm | 4,0 | 2,31 |
| Cu | 0,557 | 40 nm | 12 nm | 3,3 | 1,86 |
| Cr | 0,420 | 18 nm | 5 nm | 3,6 | 2,05 |
| Ti | 0,386 | 29 nm | 8,5 nm | 3,3 | 1,86 |

Aus der heuristischen Betrachtung heraus haben Silber und Gold (Ag und Au), wie zu sehen ist, einen hohen maximalen Reflexionsgrad R_{Max} und erfordern ein relativ kleines Tiefen-zu-Breiten-Verhältnis zur Reduzierung der optischen Dichte der metallischen Belichtungsmaskenschicht, in dem vorstehenden Beispiel zur Ausbildung von Transparenz. Aluminium (Al) hat zwar ein auch einen hohen maximalen Reflexionsgrad R_{Max}, erfordert aber ein höheres Tiefen-zu-Breiten-Verhältnis. Vorzugsweise kann deshalb vorgesehen sein, die Belichtungsmaskensschicht aus Silber oder Gold auszubilden.

Tabelle 2 zeigt nun die Berechnungsergebnisse, gewonnen aus strengen Beugungsberechnungen für als lineare, sinusförmige Gitter mit einem Gitterabstand von 350 nm ausgebildete Reliefstrukturen mit unterschiedlichen Tiefen-zu-Breiten-Verhältnissen. Die Reliefstrukturen sind mit Silber beschichtet mit einer nominalen Dicke t₀ = 40 nm. Das Licht, das auf die Reliefstrukturen auftrifft, hat die Wellenlänge λ = 550 nm (grün) und ist TE-polarisiert bzw. TMpolarisiert.

**Tabelle 2**

| Tiefen-zu-Breiten-Verhältnis | Gitterabstand in nm | Tiefe in nm | Reflexionsgrad (0R) TE | Transparenzgrad (0T) TE | Reflexionsgrad (0R) TM | Transparenzgrad (0T) TM |
|---|---|---|---|---|---|---|
| 0 | 350 | 0 | 84,5 % | 9,4 % | 84,5 % | 9,4 % |
| 0,3 | 350 | 100 | 78,4 % | 11,1 % | 50,0 % | 21,0 % |
| 0,4 | 350 | 150 | 42,0 % | 45,0 % | 31,0 % | 47,0 % |
| 1,1 | 350 | 400 | 2,3 % | 82,3 % | 1,6 % | 62,8 % |
| 2,3 | 350 | 800 | 1,2 % | 88,0 % | 0,2 % | 77,0 % |

Wie sich zeigte, ist die Transmission ausser vom Tiefen-zu-Breiten-Verhältnis auch abhängig von der Polarisation des aufgestrahlten Lichtes. Diese Abhängigkeit ist in Tabelle 2 für das Tiefen-zu-Breiten-Verhältnis h/d = 1,1 dargestellt. Es kann vorgesehen sein, diesen Effekt für die selektive Ausbildung von Funktionsschichten zu nutzen.

Weiterhin zeigte sich, dass der Transparenzgrad bzw. der Reflexionsgrad der Belichtungsmasken wellenlängenabhängig ist. Dieser Effekt ist besonders gut für TE-polarisiertes Licht ausgeprägt.

Weiterhin zeigte sich, dass der Transparenzgrad bzw. die Transmission abnimmt, wenn der Einfallswinkel des Lichtes sich vom normalen Einfallswinkel unterscheidet, d.h. der Transparenzgrad nimmt ab, wenn das Licht nicht senkrecht einfällt. Das bedeutet, dass die Belichtungsmaskenschicht nur in einem begrenzten Einfallskegel des Lichtes transparent bzw. transparenter ausgebildet sein kann. Es kann also vorgesehen sein, dass die Belichtungsmaskenschicht bei schräger Beleuchtung opak oder undurchlässig ausgebildet ist, wobei auch dieser Effekt für die selektive Ausbildung weiterer Funktionsschichten nutzbar ist.

Neben dem Tiefen-zu-Breiten-Verhältnis einer Reliefstruktur wird die Veränderung der optischen Dichte auch durch die Spatialfrequenz der Reliefstruktur beeinflusst. So hat sich weiter gezeigt, dass eine Veränderung des Transmissionsverhaltens einer auf eine Reliefstruktur aufgebrachten Belichtungsmaskenschicht erzielt werden kann, wenn das Produkt aus Spatialfrequenz und Relieftiefe in einem ersten Bereich der Reliefstruktur grösser als das Produkt aus Spatialfrequenz und Relieftiefe in einem zweiten Bereich der Reliefstruktur ist.

Die Ausbildung von Bereichen unterschiedlicher Transparenz bzw. Transmission kann aber auch durch andere Effekte erreicht werden, beispielsweise durch
- die Polarisationsabhängigkeit der Transmission infolge unterschiedlich orientierter Strukturen;
- den Formfaktor der Strukturen, d.h. Strukturen mit rechteckförmigem, sinusförmigem, sägezahnförmigem oder sonstigem Profil können bei gleichem Produkt aus Spatialfrequenz und Relieftiefe eine unterschiedliche Transmission aufweisen;
- gerichtetes Aufdampfen der Belichtungsmaskenschicht in Kombination mit speziellen Strukturen bzw. Strukturkombinationen oder Strukturanordnungen.

Wenn es sich bei der ersten Reliefstruktur um eine Struktur mit einem stochastischen Profil handelt, beispielsweise um eine Mattstruktur, können Korrelationslänge, Rauhtiefe und statistische Verteilung des Profils typische Kenngrössen sein, welche die Transmission beeinflussen.

Zur Ausbildung von Bereichen mit unterschiedlicher Transparenz oder Transmission ist es so auch möglich, im ersten Bereich und im zweiten Bereich Reliefstrukturen zu verwenden, die sich in ein oder mehreren der oben aufgeführten Parameter unterscheiden.

In einer zweiten Variante des erfindungsgemässen Verfahrens wird die Unterseite des Trägersubstrats präpariert, indem in dem ersten Bereich eine erste Reliefstruktur und in dem zweiten Bereich und im Register zur ersten Reliefstruktur mindestens eine, zur ersten Reliefstruktur unterschiedliche zweite Reliefstrukturen gebildet wird, dass im Register zur ersten Reliefstruktur die auf die Oberseite des Trägersubstrat aufgebrachte erste Funktionsschicht strukturiert wird und dass im Register zu der mindestens einen zweiten Reliefstruktur die mindestens eine auf die Oberseite des Trägersubstrats aufgebrachte zweite Funktionsschicht strukturiert wird.

Die unterschiedlichen Belichtungseigenschaften ergeben sich hier aufgrund der unterschiedlichen Beugung, Brechung oder Reflexion der Belichtungsstrahlung an den gebildeten Reliefstrukturen.

Die erste und zweite Belichtungsstrahlung unterscheidet sich bei diesem Ausführungsbeispiel bevorzugt in ihrem Einfallswinkel und/oder in ihrer Wellenlänge. So ist es beispielsweise möglich, als erste und zweite Reliefstrukturen Linsenstrukturen, beispielsweise Zylinder-Linsen oder Freiform-Linsen, vorzusehen, die bei unterschiedlichem Einfall der Belichtungsstrahlung das einfallende Licht im ersten Bereich oder im zweiten Bereich fokusieren und so die Durchlässigkeit des Trägersubstrats im ersten und zweiten Bereich abhängig von der Belichtungsrichtung erhöhen. Weiter ist es möglich, diffraktive Reliefstrukturen auf der Unterseite des Trägersubstrats vorzusehen, welche das Licht in Abhängigkeit von Einfallswinkel und/oder von der Wellenlänge durch Beugung in unterschiedlichen Bereichen fokusieren. So ist es zum einen möglich, diffraktive Linsen vorzusehen, die abhängig von der Wellenlänge des einfallenden Lichts einen unterschiedlichen Fokus besitzen und so das Licht bei einer ersten Belichtungsstrahlung im ersten Bereich und bei einer zweiten Belichtungsstrahlung, die sich von der ersten Belichtungsstrahlung in ihrer Wellenlänge unterscheidet, im zweiten Bereich fokusieren. Weiter ist es möglich, Blazegitter zu verwenden, die sich durch ein sägezahnförmiges Reliefprofil auszeichnen. Hierbei ist es möglich, den Einfallswinkel bezüglich der Flanken des Sägezahns so zu wählen, dass bei einem ersten Einfallswinkels des Lichts eine Totalreflexion (bei Aufbringen einer speziellen LRI-Schicht (auf die Blazestruktur) - (LRI = Low Refractive Index) - an der Flanke des Sägezahns stattfindet und bei einem zweiten Einfallswinkel des Lichts die Lichtstrahlen auf den durch den Brechungswinkel bestimmten Bereich gelenkt werden. Weiter ist es möglich, durch geeignete Wahl der Blazeparameter (Tiefe, Periode, Material, etc.) zu erreichen, dass zumindest ein signifikanter Unterschied in der transmittierten Intensität für die beiden Einfallswinkel existiert.

Weiter ist es auch möglich, dass die ersten und zweiten Reliefstrukturen mit einer optischen Trennschicht, beispielsweise einer HRI-Schicht (z.B. ZnS) versehen werden.

Mittels der ersten und zweiten Variante des Verfahren lassen sich strukturierte Funktionsschichten sehr hoher Auflösung erzielen. Die erzielbare Registrierung und Auflösung ist etwa um den Faktor 100 besser als durch bekannte Strukturierungsverfahren erzielbar. Da die Breite der Strukturelemente der ersten Reliefstruktur im Bereich der Wellenlänge des sichtbaren Lichtes (circa 380 bis 780 nm), aber auch darunter liegen kann, können Funktionsschichtbereiche mit sehr feinen Konturen ausgebildet werden. Damit werden auch in dieser Hinsicht grosse Vorteile gegenüber den bisher verwendeten Verfahren erzielt, da eine weitere Miniaturisierung des Bauelements erfolgen kann.

Es können Linien und/oder Punkte mit hoher Auflösung erzeugt werden, beispielsweise mit einer Breite bzw. einem Durchmesser von weniger als 5 µm, insbesondere bis etwa 200 nm. Vorzugsweise werden Auflösungen im Bereich von etwa 0,5 µm bis 5 µm, insbesondere im Bereich von etwa 1 µm, erzeugt. Demgegenüber sind mit Verfahren, die eine Justierung der strukturierten Funktionsschichten im Register vorsehen, Linienbreiten kleiner als 10 µm nur mit sehr hohem Aufwand realisierbar.

Es ist bevorzugt, wenn die erste und/oder die mindestens eine zweite Reliefstruktur als diffraktive Reliefstrukturen ausgebildet werden. Dabei hat es sich bewährt, wenn sich die erste und die mindestens eine zweite Reliefstruktur in ihrem Azimut unterscheiden.

Die erste und/oder die mindestens eine zweite Reliefstruktur werden insbesondere als Gitterstruktur, wie Lineargitter oder Kreuzgitter, als isotrope oder anisotrope Mattstruktur, als binäre oder kontinuierliche Fresnellinse, als Mikroprisma, als Blazegitter, als Kombinationsstruktur oder als Makrostruktur ausgebildet:
Lineargitter: z.B. Sinusgitter mit Linienzahlen von 100 l/mm bis 5000 l/mm und Strukturtiefen von 50 nm bis 5 um.
Kreuzgitter: z.B. Sinusgitter mit Linienzahlen von 100 l/mm bis 5000 l/mm und Strukturtiefen von 50 nm bis 5 µm.
Mattstrukturen (isotrop/anisotrop): Korrelationslängen von 0,5 µm bisss 50µm und Strukturtiefen von 50 nm bis 10 µm.
Blazegitter oder Mikroprismen: Linienzahlen von 10 l/mm bis 3000 l/mm und Strukturtiefen von 25 nm bis 10µm.
Makrostruktur: beliebig geformte Oberflächenstrukturen, charakterisiert durch maximale Tiefe von 100 nm bis 10µm, mit grossen Entfernungen (≥ 100 µm) zwischen Unsteigkeitsstellen des Oberflächenprofils.
Kombinatonsstrukturen: ergeben sich aus Kombinationen oben genannter Strukturen.

Gemäss einer dritten Variante des erfindungsgemässen Verfahrens wird die Unterseite des Trägersubstrats präpariert, indem in dem ersten Bereich eine erste Farbschicht und in dem zweiten Bereich und im Register zur ersten Farbschicht mindestens eine, zur ersten Farbschicht farblich unterschiedliche zweite Farbschicht angeordnet wird, und dass im Register zur ersten Farbschicht die auf die Oberseite des Trägersubstrat aufgebrachte erste Funktionsschicht strukturiert wird und dass im Register zu der mindestens einen zweiten Farbschicht die mindestens eine auf die Oberseite des Trägersubstrats aufgebrachte zweite elektrische Funktionsschicht strukturiert wird. Die unterschiedlichen Farbschichten wirken dabei als Filter für Belichtungsstrahlungen unterschiedlicher Wellenlängen.

Dabei wird beispielsweise im ersten Bereich musterförmig eine rote Farbschicht aufgedruckt, welche für eine blaue erste Belichtungsstrahlung durchlässig ist, und in einem zweiten Bereich eine blaue Farbschicht aufgedruckt, welche für eine rote zweite Belichtungsstrahlung durchlässig ist. Von der ersten und zweiten Farbschicht freie Bereiche des Trägersubstrats lassen beide Belichtungsstrahlungen durch, während Bereiche, welche mit beiden Farbschichten bedeckt sind, keine der beiden Belichtungsstrahlungen durchlassen.

Gemäss der ersten, zweiten oder dritten Variante wird auf die Oberseite des Trägersubstrats bevorzugt die erste Funktionsschicht vollflächig aufgebracht wird, wobei vor oder nach Bildung der ersten Funktionsschicht auf der Oberseite vollflächig eine erste photoempfindliche Schicht gebildet wird. Danach erfolgt eine Belichtung der ersten photoempfindlichen Schicht mittels der ersten Belichtungsstrahlung durch das Trägersubstrat und gegebenenfalls die Belichtungsmaskenschicht hindurch, welche im ersten Bereich für die erste Belichtungsstrahlung durchlässig ist/sind, und die erste photoempfindliche Schicht wird im Register zum ersten Bereich partiell entfernt, wobei unmittelbar oder nachfolgend eine Strukturierung der ersten Funktionsschicht erfolgt. Weiterhin wird die mindestens eine zweite Funktionsschicht vollflächig auf die Oberseite aufgebracht, wobei vor oder nach Bildung der mindestens einen zweiten Funktionsschicht vollflächig mindestens eine zweite photoempfindliche Schicht auf der Oberseite gebildet wird. Nun erfolgt eine Belichtung der mindestens einen zweiten photoempfindlichen Schicht mittels mindestens der zweiten Belichtungsstrahlung durch das Trägersubstrat und gegebenenfalls die Belichtungsmaskenschicht hindurch, welche(s) im zweiten Bereich für die zweite Belichtungsstrahlung durchlässig ist/sind, und die mindestens eine zweite photoempfindliche Schicht wird im Register zum zweiten Bereich partiell entfernt, wobei unmittelbar oder nachfolgend eine Strukturierung der mindestens einen zweiten Funktionsschicht erfolgt.

Es hat sich bewährt, wenn die Unterseite des Trägersubstrats in einem dritten Bereich derart präpariert wird, dass der dritte Bereich sowohl für die erste als auch für die mindestens eine zweite Belichtungsstrahlung durchlässig ist. Dadurch lassen sich Bereiche der strukturierten ersten und der mindestens einen strukturierten zweiten Funktionsschicht deckungsgleich übereinander anordnen. Im Falle der ersten und zweiten Variante mit Reliefstrukturen werden die unterschiedlichen Reliefstrukturen im dritten Bereich nebeneinander oder sich überlagernd ausgebildet. Im. Fall der dritten Variante werden im dritten Bereich keine Farbschichten angeordnet.

Weiterhin hat es sich bewährt, wenn die Unterseite des Trägersubstrats in einem vierten Bereich derart präpariert wird, dass der vierte Bereich undurchlässig für die erste und mindestens eine zweite Belichtungsstrahlung ist. Im Falle der ersten und zweiten Variante mit Reliefstrukturen werden keine oder ausgewählte Reliefstrukturen im dritten Bereich ausgebildet. Im Fall der dritten Variante werden im dritten Bereich alle Farbschichten angeordnet.

Somit lassen sich mindestens vier unterschiedliche Belichtungszustände realisieren:
a) Belichten nur im ersten Bereich;
b) Belichten nur im mindestens einen zweiten Bereich;
c) Belichten im ersten und im mindestens einen zweiten Bereich;
d) nicht Belichten;

Es hat sich bewährt, wenn das unpräparierte Trägersubstrat aus einem Material und/oder in einer Dicke ausgebildet wird, so dass es für die erste und/oder die mindestens eine zweite Belichtungsstrahlung durchlässig ist. Das unpräparierte Trägersubstrat kann aber auch so ausgebildet werden, dass es für die erste und/oder die mindestens eine zweite Belichtungsstrahlung undurchlässig ist und erst durch die Präparation, beispielsweise durch das Einbringen von Reliefstrukturen, oder beim Belichten, beispielsweise durch chemische Reaktionen usw., zumindest partiell für die Belichtungsstrahlung durchlässig wird.

Es hat sich bewährt, wenn die erste und die mindestens eine zweite Belichtungsstrahlung sich in ihrer Wellenlänge und/oder ihrer Polarisation und/oder ihrem Auftreffwinkeln auf die vom Trägersubstrat aufgespannte Ebene unterscheiden.

So werden für die dritte Variante des erfindungsgemässen Verfahrens insbesondere Belichtungsstrahlungen unterschiedlicher Wellenlänge eingesetzt, beispielsweise rote Strahlung als erste Belichtungsstrahlung und blaue Strahlung als die mindestens eine zweite Belichtungsstrahlung in Kombination mit einer blauen und mit einer roten Farbschicht als erste und zweite Farbschichten.

Zwischen der strukturierten ersten und der mindestens einen strukturierten zweiten Funktionsschicht kann vollflächig oder teilweise unterbrochen mindestens eine dritte Funktionsschicht ausgebildet werden. Dabei hat es sich bewährt, wenn die mindestens eine dritte Funktionsschicht aus einem halbleitenden oder einem elektrisch isolierenden Funktionsschichtmaterial gebildet wird.

Generell müssen Funktionsschichten, wie auch das Trägersubstrat, welche zwischen der Bestrahlungslichtquelle und einer photoempfindlichen Schicht im Strahlengang liegen, eine Mindest-Durchlässigkeit für die jeweilige Belichtungsstrahlung aufweisen, damit eine partielle Belichtung der photoempfindlichen Schicht erfolgen kann. Dabei ist nicht nur der visuelle Eindruck (opak - transparent) entscheidend, sondern lediglich die Transmission der jeweiligen Schicht.

Bevorzugt wird die erste Funktionsschicht aus einem elektrisch leitenden Funktionsschichtmaterial gebildet, um insbesondere Leiterbahnen und/oder Elektrodenflächen auszubilden.

Die strukturierte zweite Funktionsschicht wird, je nach Erfordernis des gebildeten Bauelements, aus einem elektrisch leitenden oder einem halbleitenden oder einem dielektrischen Funktionsschichtmaterial gebildet.

Generell können elektrisch leitende Funktionsschichten in einem Zwischenschritt galvanisch verstärkt werden, um die elektrische Leitfähigkeit zu erhöhen.

Für die drei Varianten hat es sich weiterhin bewährt, wenn mindestens eine photoempfindliche Schicht als elektrische Funktionsschicht verwendet wird. Die photoempfindliche Schicht kann nach ihrer Strukturierung beispielsweise ein elektrisch leitende Schicht, eine halbleitende Schicht oder eine dielektrische Schicht ausbilden. Weiterhin kann mindestens eine photoempfindliche Schicht während oder nach Durchführung des Verfahrens entfernt werden.

Es ist bevorzugt, wenn als photoempfindliche Schicht eine photoempfindliche Waschlackschicht oder eine positive oder negative Photoresistschicht oder eine Photopolymerschicht eingesetzt wird. Positive Photoresiste lassen sich im belichteten Bereich, negative Photoreiste im unbelichteten Bereich entfernen. Auch eine photoempfindliche Schicht, welche durch die Belichtung aktiviert wird und in den aktivierten Bereichen ein Ätzmittel für die erste und/oder die mindestens eine zweite Funktionsschicht bildet, hat sich bewährt.

Vorzugsweise wird als elektronisches Bauelement ein Kondensator ausgebildet, wobei die erste Funktionsschicht elektrisch leitend ausgebildet und in Form von zwei Kondensatorelektroden strukturiert wird und die mindestens eine zweite Funktionsschicht in Form einer strukturierten dielektrischen Schicht ausgebildet wird.

Weiterhin ist es bevorzugt, wenn als elektronisches Bauelement ein Feldeffekttransistor, insbesondere ein OFET, ausgebildet wird, wobei die erste Funktionsschicht elektrisch leitend und in Form von Source/Drain-Elektroden strukturiert ausgebildet wird, wobei eine zweite Funktionsschicht elektrisch leitend und in Form einer Gate-Elektrode strukturiert ausgebildet wird, oder umgekehrt, und wobei zwischen der ersten und der mindestens einen zweiten Funktionsschicht vollflächig eine dritte Funktionsschicht aus einer halbleitenden Schicht und vollflächig eine vierte Funktionsschicht aus einer dielektrischen Schicht gebildet werden. Dabei kann somit ein Top-Gate- oder ein Bottom-Gate-Aufbau gewählt werden.

Der Feldeffekttransistor wird insbesondere gebildet, indem auf die Oberseite des Trägersubstrats eine photoempfindliche Waschlackschicht vollflächig aufgebracht wird, indem darauf vollflächig die erste Funktionsschicht gebildet wird, dass nun die Belichtung mit der ersten Belichtungsstrahlung erfolgt, wobei die Waschlackschicht im ersten Bereich unlöslich wird, dass die Waschlackschicht inklusive der ersten Funktionsschicht in den übrigen Bereichen abgewaschen und erste Funktionsschicht strukturiert wird, dass anschliessend die dritte und die vierte Funktionsschicht gebildet werden, dass weiterhin die zweite Funktionsschicht und darauf eine Photoresistschicht vollflächig aufgebracht werden, dass nun die Belichtung mit der zweiten Belichtungsstrahlung erfolgt und die Photoresistschicht im Register zum zweiten Bereich strukturiert wird, und dass unter Verwendung der strukturierten Photoresistschicht als Ätzmaske ein Ätzen und Strukturieren der zweiten Funktionsschicht erfolgt.

Alternativ kann der Feldeffekttransistor gebildet werden, indem auf der Oberseite des Trägersubstrats vollflächig die erste Funktionsschicht gebildet und eine erste Photoresistschicht vollflächig aufgebracht wird, dass nun die Belichtung mit der ersten Belichtungsstrahlung erfolgt, dass die erste Photoresistschicht im Register zum ersten Bereich strukturiert und als Ätzmaske zum Ätzen und Strukturieren der ersten Funktionsschicht verwendet wird, dass die Ätzmaske entfernt wird, dass anschliessend die dritte Funktionsschicht und die vierte Funktionsschicht gebildet werden, dass weiterhin die zweite Funktionsschicht und darauf eine zweite Photoresistschicht vollflächig aufgebracht werden, dass nun die Belichtung mit der zweiten Belichtungsstrahlung erfolgt und die zweite Photoresistschicht im Register zum zweiten Bereich strukturiert wird, und dass unter Verwendung der strukturierten zweiten Photoresistschicht als Ätzmaske ein Ätzen und Strukturieren der zweiten Funktionsschicht erfolgt.

Es hat sich besonders bewährt, wenn ein organisches elektrisches Bauelement enthaltend zumindest eine organische Funktionsschicht gebildet wird.

Die organische Funktionsschicht wird vorzugsweise aus einer Flüssigkeit, insbesondere durch Drucken oder Rakeln, aufgebracht. Organische Funktionsschichtmaterialien können unter anderem Polymere sein, die in der Flüssigkeit gelöst sind. Die, die organischen Funktionsschichtmaterialien enthaltende Flüssigkeit kann auch eine Suspension oder Emulsion sein.

Eine organische elektrische Funktionsschicht kann alle Arten von Stoffen mit Ausnahme der klassischen Halbleiter (kristallines Silizium oder Germanium) und der typischen metallischen Leiter beinhalten. Eine Beschränkung im dogmatischen Sinne auf organisches Material im Sinne der Kohlenstoff-Chemie ist demnach nicht vorgesehen. Der Begriff des Polymers schliesst hier ausdrücklich polymeres Material und/oder oligomeres Material und/oder Material aus "small molecules" und/oder Material aus "Nano-Partikeln" ein. Schichten aus Nano-Partikeln können beispielsweise mittels einer Polymersuspension aufbracht werden. Es kann sich also bei dem Polymer auch um einen hybriden Werkstoff handeln, beispielsweise um einen n-leitenden polymeren Halbleiter auszubilden. Vielmehr sind auch beispielsweise Silicone eingeschlossen. Weiterhin soll der Begriff nicht im Hinblick auf die Molekülgrösse beschränkt sein, sondern wie weiter oben ausgeführt, "small molecules" oder "Nano-Partikel" einschliessen. Es kann vorgesehen sein, dass die organische Funktionsschicht mit unterschiedlichem organischen Material ausgebildet wird.

Als p-leitende organische Halbleitermaterialien können Pentacen, Polyalkylthiophen etc. vorgesehen sein, als n-leitende organische Halbleitermaterialien z. B. lösliche Fulleren-Derivate.

Auf dem Trägersubstrat werden bevorzugt mindestens zwei elektronische Bauelemente gebildet. Diese können auch als Bestandteil einer elektronischen Schaltung miteinander verschaltet ausgebildet werden.

Insbesondere wird das Trägersubstrat aus einem kostengünstigen flexiblen Folienmaterial, insbesondere einem transparenten Kunststofffolienmaterial, mit einer Schichtdicke im Bereich von 3 µm bis 150 µm ausgebildet. Besonders bevorzugt sind hierbei Folien aus PET, PC, PEN.Aber auch die Verwendung starrer Trägersubstrate, beispielsweise aus Glas, ist möglich.

Besonders bevorzugt ist es, wenn das Trägersubstrat bandförmig ausgebildet und in einem kontinuierlichen Verfahren von Rolle-zu-Rolle verarbeitet wird. Dabei wird das Trägersubstrat auf eine Vorratsrolle aufgewickelt bereitgestellt, von dieser abgezogen und in dem erfindungsgemässen Verfahren mit den Funktionsschichten des mindestens einen elektrischen Bauelements beschichtet und schliesslich wieder auf eine weitere Vorratsrolle aufgewickelt oder in einzelne Bauelemente, Bauelementegruppen oder Schaltungen zerteilt, insbesondere durch Stanzen.

Das Trägersubstrat kann in einer weiteren Ausgestaltung von den elektrischen Funktionsschichten des Bauelements ablösbar ausgebildet sein. Dazu wird insbesondere eine Ablöseschicht zwischen dem Trägersubstrat und den elektrischen Funktionsschichten des mindestens einen elektrischen Bauelements vorgesehen. Ein Bauelement oder eine Bauelementgruppe kann mittels einer Kleberschicht, welche auf der dem Trägersubstrat gegenüberliegenden Seite des Bauelements angeordnet wird, auf einem separaten Träger befestigt und anschliessend das Trägersubstrat abgezogen werden. Die Verarbeitung kann dabei mittels für Transferfolien bekannten Verfahren erfolgen. Dabei fungieren die Funktionsschichten inklusive der Kleberschicht als Transferlage.

Ein erfindungsgemässes elektronisches Bauelement bzw. dessen strukturierte Funktionsschichten können aufgrund der geringen Dicke des Trägersubstrats einen Verzug im Bereich von 0 bis 10 % aufweisen. Der Verzug berechnet sich dabei aus der Formabweichung der strukturierten Funktionsschicht im Hinblick auf ihre Idealform.

Das gebildete elektronische Bauelement passt sich insbesondere flexibel einer Gerätekontur oder ähnlichem an, so dass insbesondere eine Verwendung für RFID-Tags, auf Verpackungsmaterial, Etiketten oder ähnlichem möglich ist.

Das elektronische Bauelement ist vorzugsweise als ein Kondensator, ein Feldeffekttransistor, insbesondere ein OFET, eine LED, insbesondere eine OLED, oder als Diode ausgebildet.

Die Bildung elektronische Schaltungen, insbesondere organischer elektronischer Schaltungen, mit mindestens einem erfindungsgemässen elektronischen Bauelement ist ideal. Dabei kann auch die Schaltung derart ausgebildet werden, dass diese sich flexibel einer Gerätekontur oder ähnlichem anpasst.

Die Figuren 1a bis 2f sollen das erfindungsgemässe Verfahren beispielhaft erläutern. So zeigt:
- Figur 1a: eine präparierte Unterseite eines Trägersubstrats;
- Figur 1b: das Trägersubstrat aus Figur 1 im Schnitt A - A';
- Figur 1c: die Oberseite des Trägersubstrats aus Figur 1a bei Belichtung mit einer ersten Belichtungsstrahlung;
- Figur 1d: die Oberseite des Trägersubstrats aus Figur 1a bei Belichtung mit einer zweiten Belichtungsstrahlung;
- Figur 2a: das Trägersubstrat aus Figur 1 im Schnitt A - A' mit darauf aufgebrachter erster Funktionsschicht und erster negativer Photoresistschicht;
- Figur 2b: das Trägersubstrat aus Figur 2a nach Strukturierung der Photoresistschicht und Ätzen der ersten Funktionsschicht;
- Figur 2c: das Trägersubstrat aus Figur 2a nach Entfernung der ersten Photoresistschicht in der Draufsicht;
- Figur 2d: das Trägersubstrat aus Figur 2c mit darauf aufgebrachter zweiter Funktionsschicht und zweiter positiver Photoresistschicht;
- Figur 2e: das Trägersubstrat aus Figur 2d nach Strukturierung der zweiten Photoresistschicht und Ätzen der zweiten Funktionsschicht; und
- Figur 2f: das Trägersubstrat aus Figur 2e nach Entfernung der zweiten Photoresistschicht in der Draufsicht.

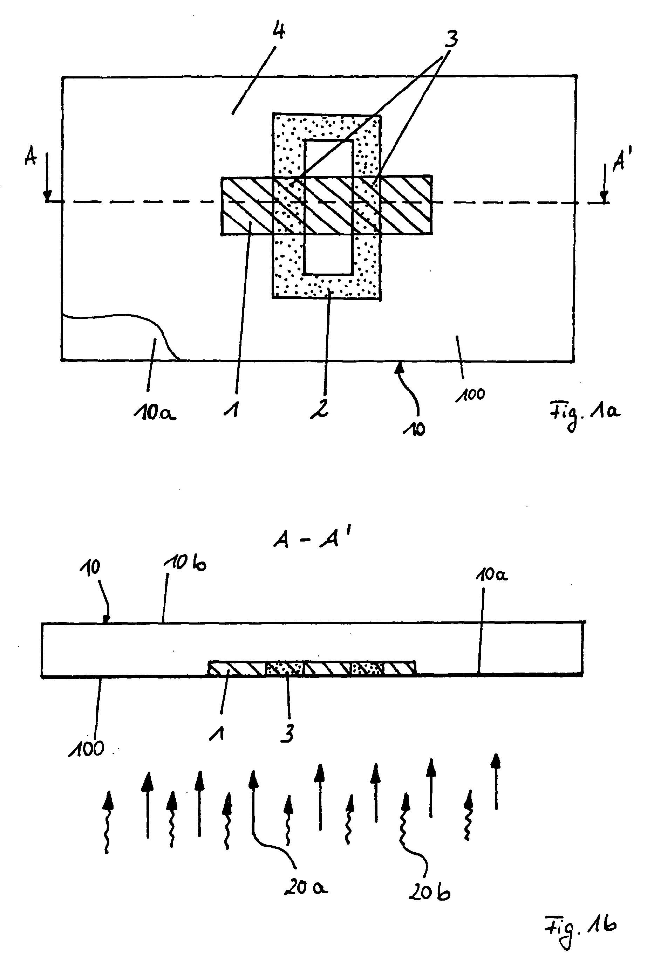

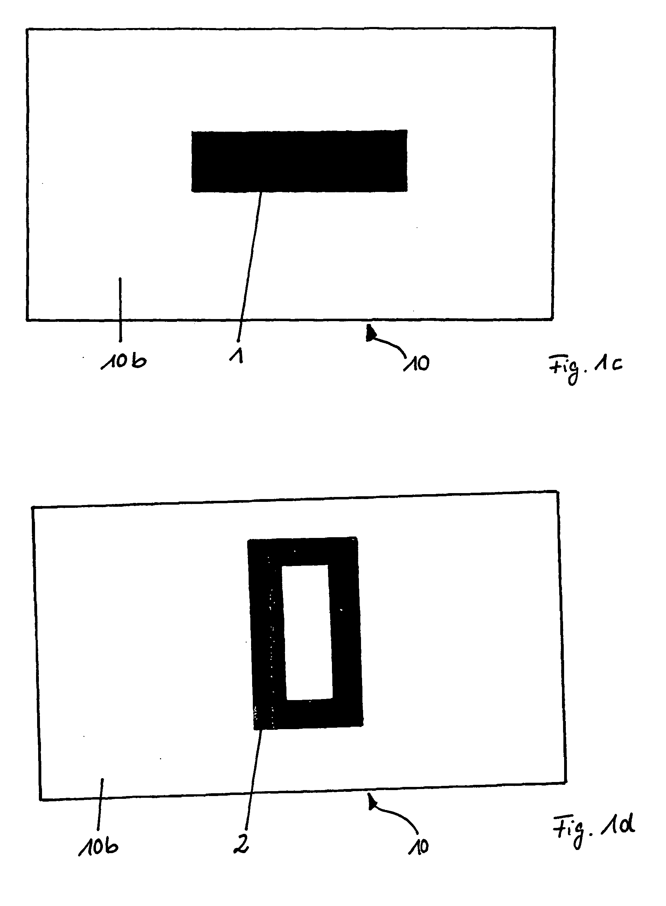

Figur 1a zeigt ein Trägersubstrat 10 aus transparentem PET, welches eine präparierte Unterseite 10a aufweist. Figur 1 b zeigt das Trägersubstrat 10 aus Figur 1 a im Schnitt A - A'. Die Oberseite des Trägersubstrats 10 ist mit dem Bezugszeichen 10b bezeichnet. Die Unterseite 10a ist in einem ersten Bereich 1 mit einer ersten diffraktiven Reliefstruktur und in einem zweiten Bereich 2 mit einer zweiten diffraktiven Reliefstruktur versehen. Hierzu wird, wie bereits oben erläutert, in die Unterseite 10a des Trägersubstrats die erste und zweite Reliefstruktur direkt abgeformt oder die erste und zweite Reliefstruktur in eine auf der Unterseite vorgesehene Replizierlackschicht abgeformt. Bei der ersten und zweiten Reliefstruktur handelt es sich beispielsweise jeweils um Sinusgitter mit einer Relieftiefe von 400 nm und einer Gitterperiode von 350 nm, wobei die Gitterlinien des Sinusgitters der ersten Reliefstruktur zu den Gitterlinien des Sinusgitters der zweiten Reliefstruktur zueinander im wesentlichen senkrecht angeordnet sind. Wie aus der Tabelle 2 erkennbar ist, ergibt sich für derartige Sinusgitter ein Transparenzgrad von 82,3 % für die TE-Polarisationsrichtung und 62,8 % für die TM-Polarisationsrichtung. Bei einer Beleuchtung der ersten und zweiten Reliefstruktur ergibt sich so für die beiden unterschiedlichen Polarisationsrichtungen ein relativer Transparenzunterschied von 30 %.

Weiter ist es auch möglich, für die erste und zweite Reliefstruktur andere Beugungsstrukturen mit einer Gitterperiode kleiner als der Wellenlänge des für die Bestrahlung verwendeten Lichts einzusetzen, bei denen sich der Azimutwinkel der ersten und zweiten Reliefstruktur unterscheidet und das Tiefen-zu-Breiten-Verhältnis der Reliefstruktur bevorzugt grösser als 0,3 ist. Insbesondere können hier die in der Tabelle 2 beispielhaft aufgeführten Reliefstrukturen mit einer Gitterperiode von 350 nm und einer Tiefe von 100 nm oder 800 nm verwendet werden, wobei hierbei bevorzugt der Azimutwinkel der ersten und zweiten Reliefstruktur eine Winkeldifferenz von etwa 90° aufweisen.

Auf die ersten und zweiten Reliefstrukturen ist eine Beschichtungsmaskenschicht 100 aus Silber in einer konstanten Flächendichte bezogen auf die vom Trägersubstrat 10 aufgespannte Ebene vollflächig aufgesputtert.

Der erste Bereich 1 ist so für eine gemäss den Gitterlinien der ersten Reliefstruktur orientiert, TE-polarisiertes Licht transparenter als der zweite Bereich. Umgekehrt ist der zweite Bereich für ein 90° hierzu polarisiertes Licht durchlässiger als der erste Bereich. Im dritten Bereich, in dem eine Überlagerung der ersten und zweiten Reliefstruktur vorgesehen ist (hier kreuzförmiges Sinusgitter mit einer Tiefe von 400 nm und einer Gitterperiode von 350 nm) besteht die höhere Durchlässigkeit für beide Polarisationsrichtungen. Wird so als erste Belichtungsstrahlung 20a eine Belichtung mit linear polarisiertem Licht einer Wellenlänge λ = 550 nm gewählt, deren Polarisationsrichtung so gewählt ist, dass das Licht bezüglich der ersten Reliefstruktur TE-polarisiert ist, so besteht eine höhere Durchlässigkeit (Transparenz) für die erste Belichtungsstrahlung 20a im ersten und dritten Bereich. Für eine zweite Belichtungsstrahlung 20b, bei der es sich um eine Belichtung mit linear polarisiertem Licht einer Wellenlänge von 550 nm und mit einer zu der Polarisationsrichtung der Belichtungsstrahlung 20a um 90° verdrehten Polarisationsrichtung handelt, ergibt sich eine erhöhte Durchlässigkeit in dem zweiten Bereich 2 und dem dritten Bereich 3.

In einem vierten Bereich 4 ohne Reliefstruktur liegt die Belichtungsmaskenschicht 100 opak und in einer Schichtdicke vor, so dass der vierte Bereich 4 undurchlässig für die erste und die zweite Belichtungsstrahlung 20a, 20b ausgebildet ist.

Figur 1c zeigt die Oberseite 10b des Trägersubstrats 10 aus Figur 1a bei Belichtung der Unterseite 10a mit der ersten Belichtungsstrahlung 20a. Im ersten Bereich 1 weist die Belichtungsmaskenschicht 100 auf der Unterseite 10a eine erhöhte Durchlässigkeit für die erste Belichtungsstrahlung 20a auf..

Figur 1d zeigt die Oberseite 10b des Trägersubstrats 10 aus Figur 1a bei Belichtung der Unterseite 10a mit der zweiten Belichtungsstrahlung 20b. Lediglich im zweiten Bereich 2 weist die Belichtungsmaskenschicht 100 auf der Unterseite 10a eine erhöhte Durchlässigkeit für die zweite Belichtungsstrahlung 20b auf.

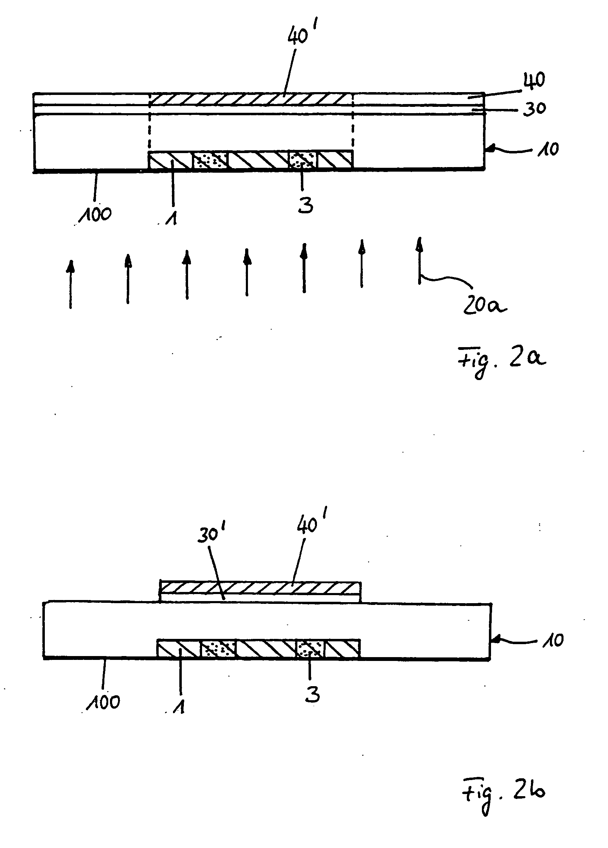

Figur 2a zeigt das Trägersubstrat 10 aus Figur 1a im Schnitt A - A' mit vollflächig darauf aufgebrachter erster Funktionsschicht 30 aus Kupfer in einer Schichtdicke von 0,1 µm bis 0,5 µm und weiterhin einer vollflächig aufgebrachten ersten negativen Photoresistschicht 40. Von der Unterseite 10a des Trägersubstrats 10 her dringt die erste Belichtungsstrahlung 20a verstärkt im ersten Bereich 1 durch die Belichtungsmaskenschicht 100, die Trägerschicht 10 sowie die erste Funktionsschicht 30 hindurch und führt zu einer partiell stärkeren Belichtung der ersten Photoresistschicht 40. Die Belichtungsdauer und die Belichtungsstärke wird hierbei so auf den für die Photoresistschicht 40 verwendeten Photoresist abgestimmt, dass das Photoresist in dem partiell stärker belichteten Bereich 1 aktiviert wird, in den schwächer belichteten Bereich 2 und 4 jedoch nicht aktiviert wird.

Die aktivierten Photoresist-Bereiche 40' verbleiben bei der Entwicklung und Strukturierung des Photoresists auf der ersten Funktionsschicht 30 und bilden eine Ätzmaske für die erste Funktionsschicht 30.

Figur 2b zeigt das Trägersubstrat 10 aus Figur 2a nach einem Ätzen der ersten Funktionsschicht 30. Es wurden die Bereiche der ersten Funktionsschicht 30 entfernt, welche nicht von der Ätzmaske bedeckt waren, so dass eine strukturierte erste Funktionsschicht 30' gebildet wurde.

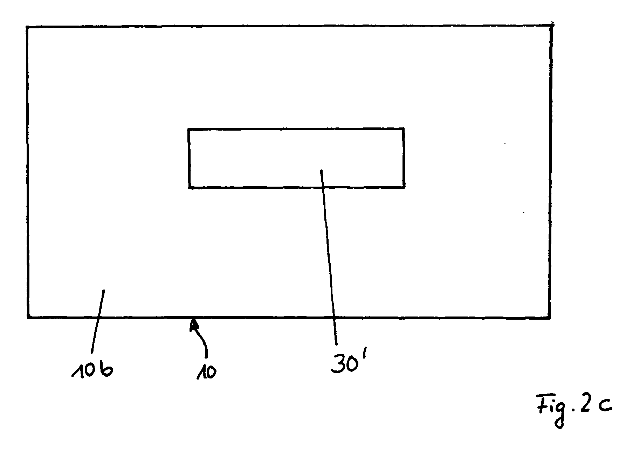

Figur 2c zeigt das Trägersubstrat 10 aus Figur 2b nach Entfernung der Ätzmaske in der Draufsicht. Die strukturierte erste Funktionsschicht 30' liegt auf der Oberseite 10a des Trägersubstrats 10 im Register zum ersten Bereich 1 vor (vergleiche Figur 1 c).

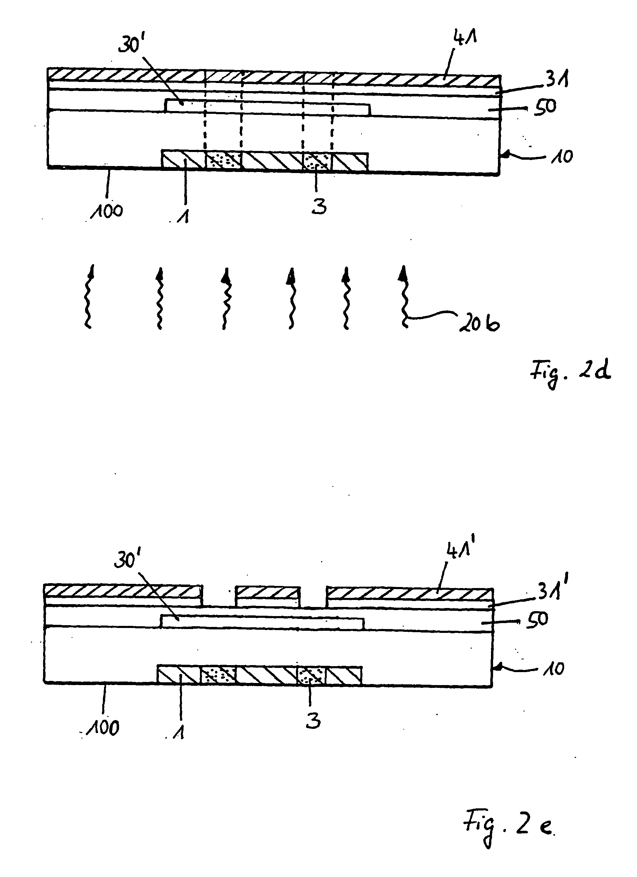

Figur 2d zeigt das Trägersubstrat 10 aus Figur 2c im Querschnitt, mit einer vollflächig auf der strukturierten ersten Funktionsschicht 30' und davon freien Bereichen des Trägersubstrats 10 aufgebrachten dritten Funktionsschicht 50 aus einem transparenten organischen dielektrischen Material. Darauf ist vollflächig eine zweite Funktionsschicht 31 aus Kupfer in einer Schichtdicke von 0,1 µm bis 0,5 µm und auf diese ebenfalls vollflächig eine zweite positive Photoresistschicht 41 aufgebracht. Von der Unterseite 10a des Trägersubstrats 10 her dringt die zweite Belichtungsstrahlung 20b verstärkt im zweiten Bereich 2 durch die Belichtungsmaskenschicht 100, die Trägerschicht 10, die erste Funktionsschicht 30, die dritte Funktionsschicht 50 und die zweite Funktionsschicht 31 hindurch und führt zu einer partiell stärkeren Belichtung der zweiten Photoresistschicht 41. Die Belichtungsdauer und die Belichtungsstärke wird hierbei so auf den für die Photoresistschicht 41 verwendeten Photoresist abgestimmt, dass das Photoresist in dem partiell stärker belichteten Bereich 2 aktiviert wird, in den schwächer belichteten Bereichen 1 und 4 jedoch nicht aktiviert wird.

Die nicht aktivierten Photoresist-Bereiche 41' verbleiben bei der Entwicklung und Strukturierung des positiven Photoresists auf der zweiten Funktionsschicht 31 und bilden eine Ätzmaske für die zweite Funktionsschicht 31.

Figur 2e zeigt das Trägersubstrat 10 aus Figur 2d nach Entwicklung und Strukturierung der zweiten Photoresistschicht, bzw. deren verbliebenen unbelichteten Bereiche 41', und nach einem Ätzen der zweiten Funktionsschicht 31, wobei die strukturierte zweite Funktionsschicht 31' gebildet wurde.

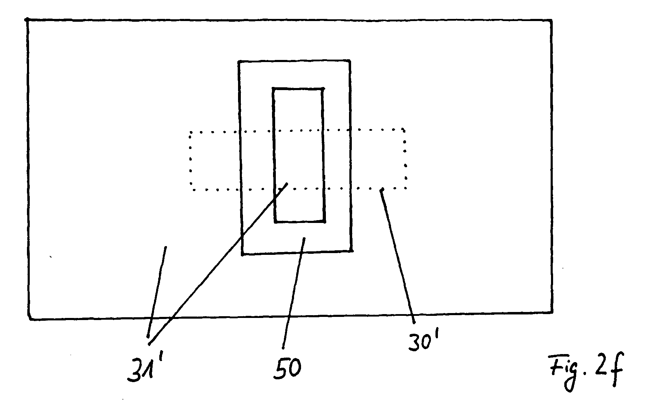

Figur 2f zeigt das Trägersubstrat 10 aus Figur 2e nach Entfernung der strukturierten zweiten Photoresistschicht 41' in der Draufsicht. Es ist die strukturierte zweite Funktionsschicht 31' auf der dritten Funktionsschicht 50 erkennbar. Die Lage der strukturierten ersten Funktionsschicht 30' unter der dritten Funktionsschicht 50 ist durch eine gepunktete Linie angedeutet. Die strukturierte erste Funktionsschicht 30' ist in perfektem Register zur strukturierten zweiten Funktionsschicht 31' abgeordnet.

## Patentansprüche

1. Verfahren zur Herstellung eines Mehrschichtkörpers, insbesondere eines Mehrschichtkörpers mit mindestens einem elektronischen Bauelement, wobei der Mehrschichtkörper mindestens zwei Funktionsschichten, insbesondere elektrische Funktionsschichten, auf einer Oberseite (10b) eines Trägersubstrats (10) umfasst, welche im Register zueinander strukturiert sind,
**dadurch gekennzeichnet,**
**dass** eine Unterseite (10a) des Trägersubstrats (10) derart präpariert wird, dass in einem ersten Bereich (1) eine gegenüber einem mindestens einen zweiten Bereich erhöhte Durchlässigkeit für eine erste Belichtungsstrahlung (20a) und in dem mindestens einen zweiten Bereich (2) eine gegenüber dem ersten Bereich erhöhte Durchlässigkeit für mindestens eine dazu unterschiedliche zweite Belichtungsstrahlung (20b) im Register zum ersten Bereich (1) resultiert, dass die Unterseite (10a) nacheinander mit der ersten und der mindestens einen zweiten Belichtungsstrahlung (20a, 20b) belichtet wird, und dass die erste Belichtungsstrahlung (20a) zur Strukturierung einer ersten Funktionsschicht (30) und die mindestens eine zweite Belichtungsstrahlung (20b) zur Strukturierung mindestens einer zweiten Funktionsschicht (31) auf der Oberseite (10b) des Trägersubstrats (10) verwendet wird.

2. Verfahren nach Anspruch 1,
**dadurch gekennzeichnet,**
**dass** die Unterseite (10a) des Trägersubstrats (10) präpariert wird, indem im ersten Bereich (1) eine erste Reliefstruktur und im zweiten Bereich (2) und im Register zur ersten Reliefstruktur mindestens eine, zur ersten Reliefstruktur unterschiedliche zweite Reliefstruktur gebildet wird, dass auf die Unterseite (10a) weiterhin eine Belichtungsmaskenschicht (100) aufgebracht wird, wobei die Belichtungsmaskenschicht (100) mit einer konstanten Flächendichte bezogen auf eine vom Trägersubstrat (10) aufgespannte Ebene aufgebracht wird, dass im Register zur ersten Reliefstruktur die auf die Oberseite (10b) des Trägersubstrats (10) aufgebrachte erste Funktionsschicht (30) strukturiert wird und dass im Register zu der mindestens einen zweiten Reliefstruktur die mindestens eine auf die Oberseite (10b) des Trägersubstrats (10) aufgebrachte zweite elektrische Funktionsschicht (31) strukturiert wird.

3. Verfahren nach Anspruch 2,
**dadurch gekennzeichnet,**
**dass** die Belichtungsmaskenschicht (100) von einer Metallschicht oder von einer Schicht aus einer Metalllegierung gebildet wird.

4. Verfahren nach einem der vorhergehenden Ansprüche,
**dadurch gekennzeichnet,**
**dass** die erste und die zweite Reliefstruktur von diffraktiven Reliefstrukturen mit einem Tiefen-zu-Breiten-Verhältnis der einzelnen Strukturelemente von ≥ 0,3 gebildet werden.

5. Verfahren nach einem der vorhergehenden Ansprüche,
**dadurch gekennzeichnet,**
**dass** die ersten und zweiten Reliefstrukturen von Reliefstrukturen mit einer Gitterperiode ≤ 800 nm, bevorzugt ≤ 500 nm gebildet werden.

6. Verfahren nach Anspruch 1,
**dadurch gekennzeichnet,**
**dass** die Unterseite (10a) des Trägersubstrats (10) präpariert wird, indem in dem ersten Bereich (1) eine erste Reliefstruktur und in dem zweiten Bereich (2) und im Register zur ersten Reliefstruktur mindestens eine, zur ersten Reliefstruktur unterschiedliche zweite Reliefstrukturen gebildet wird, dass im Register zur ersten Reliefstruktur die auf die Oberseite (10b) des Trägersubstrats (10) aufgebrachte erste Funktionsschicht (30) strukturiert wird und dass im Register zu der mindestens einen zweiten Reliefstruktur die mindestens eine auf die Oberseite (10b) des Trägersubstrats (10) aufgebrachte zweite elektrische Funktionsschicht (31) strukturiert wird.

7. Verfahren nach Anspruch 1,
**dadurch gekennzeichnet,**
**dass** die Unterseite (10a) des Trägersubstrats (10) präpariert wird, indem in dem ersten Bereich eine erste Farbschicht und in dem zweiten Bereich und im Register zur ersten Farbschicht mindestens eine, zur ersten Farbschicht farblich unterschiedliche zweite Farbschicht angeordnet wird, und dass im Register zur ersten Farbschicht die auf die Oberseite (10b) des Trägersubstrats (10) aufgebrachte erste Funktionsschicht strukturiert wird und dass im Register zu der mindestens einen zweiten Farbschicht die mindestens eine auf die Oberseite (10b) des Trägersubstrats (10) aufgebrachte zweite Funktionsschicht strukturiert wird.

8. Verfahren nach einem der Ansprüche 1 bis 7,
**dadurch gekennzeichnet,**
**dass** die strukturierte erste Funktionsschicht (30') aus einem elektrisch leitenden Funktionsschichtmaterial gebildet wird.

9. Verfahren nach einem der Ansprüche 1 bis 8,
**dadurch gekennzeichnet,**
**dass** die strukturierte zweite Funktionsschicht (31') aus einem elektrisch leitenden oder einem halbleitenden oder einem dielektrischen Funktionsschichtmaterial gebildet wird.

10. Mehrschichtkörper, insbesondere Mehrschichtkörper mit mindestens einem organischen elektronischen Bauelement, welcher ein Trägersubstrat (10) aufweist,
**dadurch gekennzeichnet,**
**dass** eine Unterseite (10a) des Trägersubstrats (10) derart präpariert ist, dass in einem ersten Bereich (1) eine gegenüber einem mindestens einen zweiten Bereich erhöhte Durchlässigkeit für eine erste Belichtungsstrahlung (20a) und in dem mindestens einen zweiten Bereich (2) eine gegenüber dem ersten Bereich erhöhte Durchlässigkeit für mindestens eine dazu unterschiedliche zweite Belichtungsstrahlung (20b) ausgebildet ist, und dass auf einer Oberseite (10b) des Trägersubstrats (10) zwei unterschiedlich strukturierte Funktionsschichten (30', 31') angeordnet sind, von der eine erste Funktionsschicht (30) strukturiert ist, sodass die erste Funktionsschicht (30') im Register zu dem ersten Bereich angeordnet ist, und wobei eine zweite Funktionsschicht (31') strukturiert ist, sodass die zweite Funktionsschicht (31') im Register zu dem zweiten Bereich (2) angeordnet ist.

11. Mehrschichtkörper nach Anspruch 10,
**dadurch gekennzeichnet,**
**dass** in dem ersten Bereich (1) eine erste Reliefstruktur und in dem zweiten Bereich (2) und im Register zur ersten Reliefstruktur mindestens eine, zur ersten Rellefstruktur unterschiedliche zweite Reliefstruktur angeordnet ist.

12. Mehrschichtkörper nach einem der Ansprüche 10 oder 11,
**dadurch gekennzeichnet,**
**dass** auf der Unterseite (10a) weiterhin eine Belichtungsmaskenschicht (100) angeordnet ist.

13. Mehrschichtkörper nach Anspruch 12,
**dadurch gekennzeichnet,**
**dass** in dem ersten Bereich (1) eine erste Farbschicht und in dem zweiten Bereich (2) und im Register zur ersten Farbschicht mindestens eine, zur ersten Farbschicht farblich unterschiedliche zweite Farbschicht angeordnet ist.

14. Mehrschichtkörper nach einem der Ansprüche 10 bis 13,
**dadurch gekennzeichnet,**
**dass** der Mehrschichtkörper ein oder mehrere elektrische Bauelemente, insbesondere einen Kondensator, einen Feldeffekttransistor, eine Solarzelle, ein eine photosensitive Schicht enthaltenes Bauelement, einen Widerstand, eine Antenne, eine LED, insbesondere eine OLED, oder eine Diode aufweist

15. Mehrschichtkörper nach einem der Ansprüche 10 bis 14,
**dadurch gekennzeichnet,**
**dass** der Mehrschichtkörper als Substrat eine Glasschicht aufweist, und dass der Mehrschichtkörper im Bereich der Unterseite eine Replizierlackschicht aufweist, in die im ersten Bereich eine erste diffraktive Reliefstruktur abgeformt ist, und In die In dem mindestens einen weiteren zweiten Bereich eine davon unterschiedliche zweite diffraktive Reliefstruktur abgeformt ist.

## Claims

1. Method for producing a multilayer body, in particular a multilayer body with at least one electronic structural element, wherein the multilayer body comprises at least two functional layers, in particular electrical functional layers, on a top side (10b) of a carrier substrate (10), which are structured in register with one another,
**characterised in that**,
an underside (10a) of the carrier substrate (10) is prepared in such a way that, in a first region (1), there results an increased level of transmissibility for a first exposure radiation (20a) compared to an at least one second region and, in at least one second region (2), there results an increased level of transmissibility for at least one second exposure radiation (20b) compared to the first region, which is different therefrom, in register with the first region (1), that the underside (10a) is successively exposed with the first and the at least one second exposure radiation (20a, 20b), and that the first exposure radiation (20a) is used for structuring a first functional layer (30) and the at least one second exposure radiation (20b) is used for structuring at least one second functional layer (31) on the top side (10b) of the carrier substrate (10).

2. Method according to claim 1,
**characterised in that**,
the underside (10a) of the carrier substrate (10) is prepared, while a first relief structure is formed in the first region (1) and, in register with the first relief structure, at least one second relief structure that differs from the first relief structure is formed in the second region (2), that, furthermore, an exposure mask layer (100) is applied to the underside (10a), wherein the exposure mask layer (100) is applied with a constant areal density with respect to a plane that is fixed by the carrier substrate (10), that the first functional layer (30) applied to the top side (10b) of the carrier substrate (10) is structured in register with the first relief structure, and that the at least one second electrical functional layer (31) applied to the top side (10b) of the carrier substrate (10) is structured in register with the at least one second relief structure.

3. Method according to claim 2,
**characterised in that**,
the exposure mask layer (100) is formed from a metallic layer or from a layer made from a metal alloy.

4. Method according to one of the preceding claims,
**characterised in that**,
the first and the second relief structure are formed by diffractive relief structures with a depth-to-width ratio of the individual structural elements of = 0.3.

5. Method according to one of the preceding claims,
**characterised in that**,
the first and second relief structures are formed from relief structures with a grating period of =800nm, preferably =500nm.

6. Method according to claim 1,
**characterised in that**,
the underside (10a) of the carrier substrate (10) is prepared, while a first relief structure is formed in the first region (1) and at least one second relief structure that differs from the first relief structure is formed in the second region (2) and in register with the first relief structure, that the first functional layer (30) applied to the top side (10b) of the carrier substrate (10) is structured in register with the first relief structure, and that the at least one second electrical functional layer (31) applied to the top side (10b) of the carrier substrate (10) is structured in register with the at least one second relief structure.

7. Method according to claim 1,
**characterised in that**,
the underside (10a) of the carrier substrate (10) is prepared, while a first layer of paint is arranged in the first region and at least one second layer of paint that differs from the first layer of paint in terms of colour is arranged in the second region and in register with the first layer of paint, and that the first functional layer applied to the top side (10b) of the carrier substrate (10) is structured in register with the first layer of paint, and that the at least one second functional layer applied to the top side (10b) of the carrier substrate (10) is structured in register with the at least one second layer of paint.

8. Method according to one of claims 1 to 7,
**characterised in that**,
the structured first functional layer (30') is formed from an electrically conductive functional layer material.

9. Method according to one of claims 1 to 8,
**characterised in that**,
the structured second functional layer (31') is formed from an electrically conductive or a semi-conductive or a dielectric functional material.

10. Multilayer body, in particular multilayer body with at least one organic, electronic structural element, which has a carrier substrate (10),
**characterised in that**,
an underside (10a) of the carrier substrate (10) is prepared in such a way that, in a first region (1), an increased level of transmissibility for a first exposure radiation (20a) compared to an at least one second region and, in at least one second region (2), an increased level of transmissibility for at least one second exposure radiation (20b) compared to the first region, is formed, and that two separately structured functional layers (30', 31') are arranged on a top side (10b) of the carrier substrate (10), with which a first functional layer (30) is structured, such that the first functional layer (30') is arranged in register with the first region, and wherein a second functional layer (31') is structured, such that the second functional layer (31') is arranged in register with the second region (2).

11. Multilayer body according to claim 10,
**characterised in that**,
a first relief structure is arranged in the first region (1) and at least one second relief structure that differs from the first relief structure is arranged in the second region (2) and in register with the first relief structure.

12. Multilayer body according to one of claims 10 or 11,
**characterised in that**,
furthermore, an exposure mask layer (100) is arranged on the underside (10a).

13. Multilayer body according to claim 12,
**characterised in that**,
a first layer of paint is arranged in the first region (1) and at least one second layer of paint that differs from the first layer of paint in terms of colour is arranged in the second region (2) and in register with the first layer of paint.

14. Multilayer body according to one of claims 10 to 13,
**characterised in that**,
the multilayer body has one or more electrical structural elements, in particular a capacitor, a field effect transistor, a solar cell, a structural element containing a photosensitive layer, a resistor, an antenna, an LED, in particular an OLED, or a diode.

15. Multilayer body according to one of claims 10 to 14,
**characterised in that**,
the multilayer body has a glass layer as a substrate, and that the multilayer body has a replicating varnish layer, into which a first diffractive relief structure is moulded in the first region, and into which a second diffractive relief structure, which is different thereto, is moulded in the at least one further second region.

## Revendications

1. Procédé de fabrication d'un corps multicouche, en particulier d'un corps multicouche avec au moins un élément structurel électronique, le corps multicouche comportant au moins deux couches fonctionnelles, en particulier des couches fonctionnelles électriques, sur un côté supérieur (10b) d'un substrat porteur (10), qui sont structurées en alignement les unes par rapport aux autres,
**caractérisé en ce**
**qu'**un côté inférieur (10a) du substrat porteur (10) est préparé de telle manière qu'il résulte dans une première zone (1) une transparence accrue par rapport à au moins une seconde zone pour un premier rayonnement d'exposition (20a) et dans l'au moins une seconde zone (2) une transparence accrue par rapport à la première zone pour au moins un second rayonnement d'exposition (20) différent en alignement par rapport à la première zone (1), en ce que le côté inférieur (10a) est exposé successivement au premier et à l'au moins un second rayonnement d'exposition (20a, 20b) et en ce que le premier rayonnement d'exposition (20a) est utilisé pour la structuration d'une première couche fonctionnelle (30) et l'au moins un second rayonnement d'exposition (20b) pour la structuration d'au moins une seconde couche fonctionnelle (31) sur le côté supérieur (10b) du substrat porteur (10).

2. Procédé selon la revendication 1,
**caractérisé en ce**
**que** le côté inférieur (10a) du substrat porteur 10) est préparé en formant dans la première zone (1) une première structure en relief et dans la seconde zone (2) et en alignement par rapport à la première structure en relief, au moins une seconde structure en relief différente de la première structure en relief, en ce qu'une couche de masque d'exposition (100) est en outre appliquée sur le côté inférieur (10a), la couche de masque d'exposition (100) étant appliquée avec une densité superficielle constante par rapport à un plan défini par le substrat porteur (10), en ce que la première couche fonctionnelle (30) appliquée sur le côté supérieur (10b) du substrat porteur (10) est structurée en alignement par rapport à la première structure en relief et en ce que l'au moins une seconde couche fonctionnelle (31) électrique appliquée sur le côté supérieur (10b) du substrat porteur (10) est structurée en alignement par rapport à l'au moins une seconde structure en relief.

3. Procédé selon la revendication 2,
**caractérisé en ce**
**que** la couche de masque d'exposition (100) est formée par une couche métallique ou une couche en un alliage métallique.

4. Procédé selon l'une quelconque des revendications précédentes,
**caractérisé en ce**
**que** les première et seconde structures en relief sont formées par des structures en relief diffractives avec un rapport profondeur-largeur des éléments structurels individuels de ≥ 0,3.

5. Procédé selon l'une quelconque des revendications précédentes,
**caractérisé en ce**
**que** les première et seconde structures en relief sont formées par des structures en relief avec un pas de réseau ≤ 800 nm, de préférence ≤ 500 nm.

6. Procédé selon la revendication 1,
**caractérisé en ce**
**que** le côté inférieur (10a) du substrat porteur (10) est préparé en formant dans la première zone (1) une première structure en relief et dans la seconde zone (2) et en alignement par rapport à la première structure en relief, au moins une seconde structure en relief différente de la première structure en relief, en ce que la première couche fonctionnelle (30) appliquée sur le côté supérieur (10b) du substrat porteur (10) est structurée en alignement par rapport à la première structure en relief et en ce que l'au moins une seconde couche fonctionnelle (31) électrique appliquée sur le côté supérieur (10b) du substrat porteur (10) est structurée en alignement par rapport à l'au moins une seconde structure en relief.

7. Procédé selon la revendication 1,
**caractérisé en ce**
**que** le côté inférieur (10a) du substrat porteur (10) est préparé en disposant dans la première zone une première couche de couleur et dans la seconde zone et en alignement par rapport à la première couche de couleur, au moins une seconde couche de couleur dont la couleur est différente de celle de la première couche de couleur, et en ce que la première couche fonctionnelle appliquée sur le côté supérieur (10b) du substrat porteur (10) est structurée en alignement par rapport à la première couche de couleur et en ce que l'au moins une seconde couche fonctionnelle appliquée sur le côté supérieur (10b) du substrat porteur (10) est structurée en alignement par rapport à l'au moins une seconde couche de couleur.

8. Procédé selon l'une quelconque des revendications 1 à 7,
**caractérisé en ce**
**que** la première couche fonctionnelle (30') structurée est formée par un matériau de couche fonctionnelle électroconducteur.

9. Procédé selon l'une quelconque des revendications 1 à 8,
**caractérisé en ce**
**que** la seconde couche fonctionnelle (31') structurée est formée par un matériau de couche fonctionnelle électroconducteur ou semi-conducteur ou diélectrique.

10. Corps multicouche, en particulier corps multicouche avec au moins un élément structurel électronique organique qui présente un substrat porteur (10),
**caractérisé en ce**
**qu'**un côté inférieur (10a) du substrat porteur (10) est préparé en réalisant dans une première zone (1) une transparence accrue par rapport à au moins une seconde zone pour un premier rayonnement d'exposition (20a) et dans l'au moins une seconde zone (2) une transparence accrue par rapport à la première zone pour au moins un second rayonnement d'exposition différent (20b) et en ce que deux couches fonctionnelles (30', 31') structurées différemment sont disposées sur un côté supérieur (10b) du substrat porteur (10), dont une première couche fonctionnelle (30) est structurée de sorte que la première couche fonctionnelle (30') soit disposée en alignement par rapport à la première zone et une seconde couche fonctionnelle (31') étant structurée de sorte que la seconde couche fonctionnelle (31') soit disposée en alignement par rapport à la seconde zone (2).

11. Corps multicouche selon la revendication 10,
**caractérisé en ce**
**qu'**une première structure en relief est disposée dans la première zone (1) et au moins une seconde structure en relief différente de la première structure en relief est disposée dans la seconde zone (2) et en alignement par rapport à la première structure en relief.

12. Corps multicouche selon l'une quelconque des revendications 10 ou 11,
**caractérisé en ce**
**qu'**une couche de masque d'exposition (100) est en outre disposée sur le côté inférieur (10a).

13. Corps multicouche selon la revendication 12,
**caractérisé en ce**
**qu'**une première couche de couleur est disposée dans la première zone (1) et au moins une seconde couche de couleur dont la couleur est différente de celle de la première couche de couleur est disposée dans la seconde zone (2) et en alignement par rapport à la première couche de couleur.

14. Corps multicouche selon l'une quelconque des revendications 10 à 13,
**caractérisé en ce**
**que** le corps multicouche présente un ou plusieurs éléments structurels électriques, en particulier un condensateur, un transistor à effet de champ, une cellule solaire, un élément structurel contenant une couche photosensible, une résistance, une antenne, une LED, en particulier une OLED ou une diode.

15. Corps multicouche selon l'une quelconque des revendications 10 à 14,
**caractérisé en ce**
**que** le corps multicouche présente comme substrat une couche de verre, et en ce que le corps multicouche présente dans la zone du côté inférieur une couche de laque de réplique, dans laquelle une première structure en relief diffractive est moulée dans la première zone, et dans laquelle une seconde structure en relief différente est moulée dans l'au moins une autre seconde zone.
